# EUROPEAN PATENT APPLICATION

(11) **EP 4 734 460 A1**
(43) Date of publication of application: **29.04.2026**
(21) Application number: 25209467.7
(22) Date of filing: 17.10.2025
(51) Int. Cl.: H04L 25/02, H10W 72/00

(54) **SOFTWARE PROGRAMMABLE ISOLATOR**

(30) Priority: 24.10.2024 US 202418925282
(71) Applicant: Analog Devices, Inc., Wilmington, MA 01887 (US)
(72) Inventor: XU, Jinglin, Wilmington, 01887 (US); CHEN, Baoxing, Wilmington, 01887 (US); YUN, Ruida, Wilmington, 01887 (US)
(74) Representative: Wallin, Nicholas James

(57) **Abstract**

Described herein are software programmable isolated devices. The isolated device may be programmable in that some of the characteristics of the isolated device may be set based upon input provided by a user. The isolated device may allow the user to program the activation or deactivation of each channel independently of the activation and deactivation of the other channels. Additionally, or alternatively, the isolated device may allow the user to program the direction of transmission of each channel independently of the direction of transmission of the other channels. Additionally, or alternatively, the isolated device may allow a user to program the data rate at which each channel communicates independently of the data rates of the other channels. Additionally, or alternatively, the isolated device may allow a user to program the delay associated with each channel independently of the delays associated with the other channels.

## Description

### BACKGROUND

### Field

The present application relates to software programmable isolators.

### Related Art

Galvanic isolation between circuit components and transmission of data and power across an isolation barrier is often provided for safety and/or data integrity considerations. Galvanic isolation is intended to prevent extraneous signals from inadvertently being processed as status or control information and and/or to protect electronic equipment from shock hazards or to permit the equipment on each side of an isolation barrier to be operated at a different supply voltage.

### BRIEF SUMMARY

Described herein are software programmable isolated devices. The isolated device may be programmable in that some of the characteristics of the isolated device may be set based upon input provided by a user. The isolated device may allow the user to program the activation or deactivation of each channel independently of the activation and deactivation of the other channels. Additionally, or alternatively, the isolated device may allow the user to program the direction of transmission of each channel independently of the direction of transmission of the other channels. Additionally, or alternatively, the isolated device may allow a user to program the data rate at which each channel communicates independently of the data rates of the other channels. Additionally, or alternatively, the isolated device may allow a user to program the delay associated with each channel independently of the delays associated with the other channels.

Some embodiments relate to an isolated device comprising an isolation barrier; a first serializer/deserializer (SerDes) coupled to a first side of the isolation barrier and a second SerDes coupled to a second side of the isolation barrier opposite the first side; a plurality of programmable channels coupled to the first and second SerDes, wherein each programmable channel, when activated, permits passage of signals across the isolation barrier; and a controller configured to individually activate or deactivate each channel of the plurality of programmable channels.

In some embodiments, the controller is configured to individually activate or deactivate each channel of the plurality of programmable channels based on input provided by a user of the isolated device.

In some embodiments, the controller is further configured to select, for each channel of the plurality of programmable channels, a direction of transmission between a first direction oriented from the first SerDes to the second SerDes and a second direction oriented from the second SerDes to the first SerDes.

In some embodiments, the controller is configured to select the direction of transmission for each channel based on input provided by a user of the isolated device.

In some embodiments, the controller is further configured to select, for each channel of the plurality of programmable channels, a mode of operation between a high-speed mode and a low-speed mode, wherein the high-speed mode results in a higher data rate than the low-speed mode.

In some embodiments, the controller is configured to select the mode of operation for each channel based on input provided by a user of the isolated device.

In some embodiments, selecting the high-speed mode comprises selecting an LVDS buffer and selecting the low-speed mode comprises selecting a CMOS buffer.

In some embodiments, each channel of the plurality of programmable channels comprises a programmable delay unit, and wherein the controller is further configured to individually control each delay unit associated with a respective channel to introduce a delay of a respective amount in the channel.

In some embodiments, the controller is configured to individually control each delay unit based on input provided by a user of the isolated device.

Some embodiments relate to an isolated device comprising an isolation barrier; a first transmitter coupled to a first side of the isolation barrier, and a first receiver coupled to a second side of the isolation barrier opposite the first side; a second transmitter coupled to the second side of the isolation barrier, and a second receiver coupled to the first side of the isolation barrier; a first serializer having a plurality of inputs and an output coupled to the first transmitter; a second serializer having a plurality of inputs and an output coupled to the second transmitter; a first deserializer having an input coupled to the first receiver and a plurality of outputs coupled to the inputs of the second serializer; and a second deserializer having an input coupled to the second receiver and a plurality of outputs coupled to the inputs of the first serializer.

In some embodiments, the isolated device further comprises a first plurality of programmable delay units coupled to the outputs of the first deserializer and a second plurality of programmable delay units coupled to the outputs of the second deserializer.

In some embodiments, the isolated device further comprises a controller configured to set delays by controlling the first and second pluralities of programmable delay units.

In some embodiments, the isolated device further comprises a controller configured to individually connect or disconnect each input of the plurality of inputs of the first serializer to the first side of the isolated barrier.

In some embodiments, the controller is further configured to individually connect or disconnect each output of the plurality of outputs of the second deserializer to the first side of the isolated barrier.

In some embodiments, the isolated barrier comprises a first isolator and a second isolator, the first isolator being coupled to the first transmitter and the first receiver, the second isolator being coupled to the second transmitter and the second receiver.

Some embodiments relate to a method for controlling an isolated device comprising an isolation barrier, a first serializer/deserializer (SerDes) coupled to a first side of the isolation barrier and a second SerDes coupled to a second side of the isolation barrier opposite the first side, and a plurality of programmable channels coupled to the first and second SerDes, the method comprising individually activating or deactivating each channel of the plurality of programmable channels to connect or disconnect the first SerDes from the second SerDes through the isolation barrier; and selecting, for each activated channel, a direction of transmission between a first direction oriented from the first SerDes to the second SerDes and a second direction oriented from the second SerDes to the first SerDes.

In some embodiments, individually activating or deactivating each channel and selecting, for each activated channel, a direction of transmission is performed based on input provided by a user of the isolated device.

In some embodiments, the method further comprises selecting, for each activated channel, a mode of operation between a high-speed mode and a low-speed mode, wherein the high-speed mode results in a higher data rate than the low-speed mode.

In some embodiments, selecting the high-speed mode comprises selecting an LVDS buffer and selecting the low-speed mode comprises selecting a CMOS buffer.

In some embodiments, each channel of the plurality of programmable channels comprises a programmable delay unit, and wherein the method further comprises: individually controlling each delay unit associated with a respective channel to introduce a delay of a respective amount in the channel.

### BRIEF DESCRIPTION OF DRAWINGS

Various aspects and embodiments of the application will be described with reference to the following figures. It should be appreciated that the figures are not necessarily drawn to scale. Items appearing in multiple figures are indicated by the same reference number in all the figures in which they appear.
FIG. 1 is a block diagram illustrating a conventional isolated device.
FIG. 2 is a block diagram illustrating a software programmable isolated device, in accordance with some embodiments.
FIG. 3 is a flow chart illustrating a method for controlling a software programmable isolated device, in accordance with some embodiments.
FIG. 4 is a block diagram illustrating the isolated device of FIG. 2 in a particular state, in accordance with some embodiments.

### DETAILED DESCRIPTION

Described herein are software programmable isolated devices. The isolated devices developed by the inventors and described herein include multiple programmable channels sharing common isolators, which can be programmable in one or more ways. In one example, the isolated device may allow the user to program the activation or deactivation of each channel independently of the activation and deactivation of the other channels, despite the fact that the channels share the same isolator. The ability to program the channel activation allows users to activate only those channels that are beneficial to the application at hand, while deactivating the other channels. As a result, power can be reduced. Additionally, or alternatively, the isolated device may allow the user to program the direction of transmission of each channel independently of the direction of transmission of the other channels. For example, a first subset of the channels may be programmed to allow signals to travel from a first terminal to a second terminal while a second subset of the channels may be programmed to allow signals to travel from the second terminal to the first terminal. The ability to program the direction of each channel allows users to customize the signal streams depending upon the needs of the application at hand. Additionally, or alternatively, the isolated device may allow a user to program the data rate at which each channel communicates independently of the data rates of the other channels. For example, a user may decide to set the data rate of signals propagating in one direction to a high-speed rate while setting the data rate of signals propagating in the opposite direction to a low-speed rate. This may be helpful in application involving signals traveling in one direction to carry data while signals traveling in the opposite direction to carry control signals. Additionally, or alternatively, the isolated device may allow a user to program the delay associated with each channel independently of the delays associated with the other channels. This allows the user to set the delays depending upon needs of the application at hand.

The software programmable nature of these isolated devices leads to several benefits relative to conventional designs. First, it gives the user more flexibility. A user may program the characteristics of each channel (e.g., activation/deactivation, direction, speed and/or delay) independently of the other channels depending upon the needs of the application. Additionally, it allows manufacturers of isolated device to commercialize flexible products that the user can adapt to various settings. In some settings, an isolated device may be used in connection with motor controllers or power converters to drive high-power transistors such as MOSFETs or IGBTs. In other settings, an isolated device may be used in communication interfaces such as UART, SPI, I2C, or USB where different voltage domains need to communicate safely. In yet other settings, an isolated device may protect patients and sensitive electronics by isolating the patient interface (which may experience electrical noise or surges) from the system's internal electronics. In yet other settings, an isolated device separates a noisy, high-voltage sensor environment from the sensitive data acquisition system, protecting the measurement accuracy and the processing circuits. Given its software programmability, the same isolated device can be adapted to satisfy any one of the settings listed above.

Second, it reduces the overall area of the isolated devices. Consider for example an isolated device including sixteen channels. Instead of having sixteen isolators, the present approach allows for multiple channels to share the same isolator. For example, sixteen channels may be achieved using one or two isolators at most, thus reducing the device area. Third, it allows the user to program the device in a way that can improve jitter performance. Jitter is a quantity that indicates rapid variations in a signal's timing. Jitter can affect the quality and accuracy of data transmission or processing. It manifests as deviations in the signal's periodicity, usually in reference to the timing of clock signals or data pulses. These fluctuations can cause synchronization errors, leading to data loss, miscommunication between components, and degraded performance, especially in systems that require precise timing like networking equipment, communication systems, or high-speed data transfer devices. As described in detail further below, the ability to program the direction of each channel independently allows the user to use one (or more) channel to send a clock signal from the receiver back to the transmitter. The transmitter can use the clock to re-time (e.g., using adjustable delays) the transmission of data in a way that reduces jitter. In one example, jitter can be reduced by as much as ten times relative to conventional isolated devices. For example, jitter can be reduced from about 400 ps to about 40 ps. Fourth, the ability to program the speed of each channel allows the user to reduce the speed of those channels that do not necessarily require high-speed communication, which in turn can reduce power consumption. In one example, high-speed channels can consume as much as 0.24mA/Mbps of current per bit rate while low-speed channels can consume as little as 0.012mA/Mbps of current per bit rate.

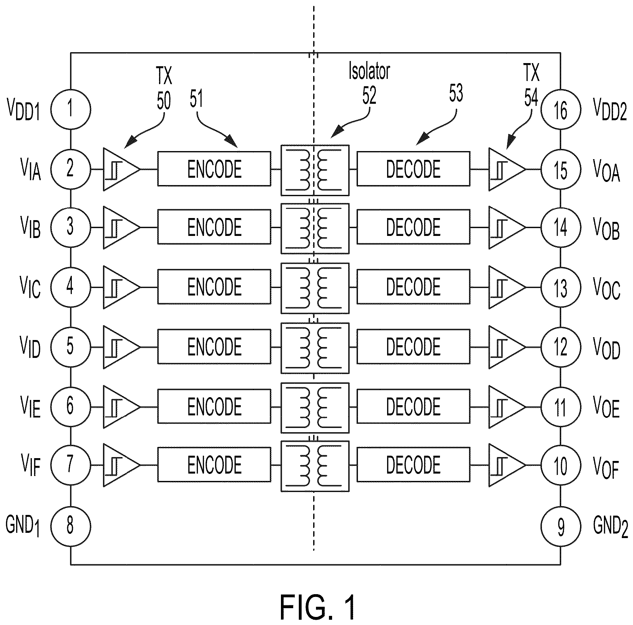

FIG. 1 is a block diagram illustrating a conventional isolated device. This device includes six isolated channels. Each channel extends from an input port to an output port. For example, the first channel extends from input port 2 to output port 15 (the voltage defined at port 2 is V_{IA} and the voltage defined at port 15 is V_{OA}). The other channels extend from input ports 3, 4, 5, 6 and 7 to output ports 14, 13, 12, 11 and 10, respectively (the input voltages are V_{IB}, V_{IC}, V_{ID}, V_{IE} and V_{IF} and the output voltages are V_{OB}, V_{OC}, V_{OD}, V_{OE} and V_{OF}). Ports 1 and 16 are connected to supply voltages (V_{DD1} and V_{DD2}) and ports 8 and 9 are connected to ground (GND₁ and GND₂) Each channel includes a transmitter (TX) 50, an encoder 51, an isolator 52, a decoder 53 and a receiver (RX) 54. Notably, each channel includes a dedicated isolator 52.

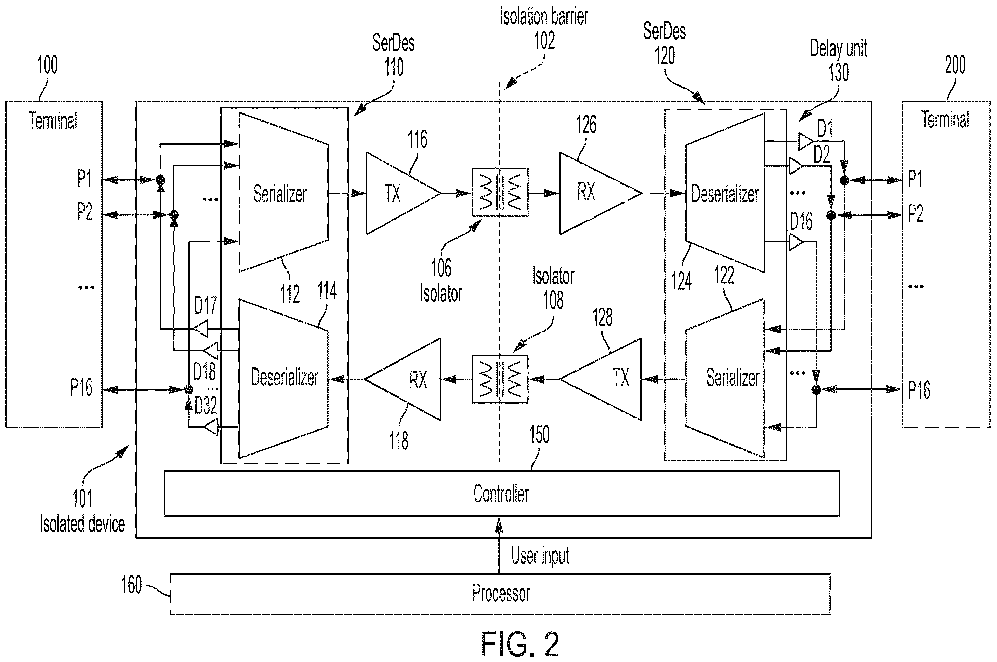

The inventors have recognized and appreciated that isolated devices of the types shown in FIG. 1 have limited applicability due to their static nature. FIG. 2 is a block diagram illustrating a software programmable isolated device, in accordance with some embodiments. The isolated device is programmable in that some of the characteristics of the isolated device may be set based upon user input. Unlike the isolated device of FIG. 1, the isolate device of FIG. 2 includes fewer than one isolator per channel. What makes this possible is the presence of programmable serializers/deserializers (SerDes). A SerDes is a hardware component that converts data from serial to parallel and from parallel to serial. Use of SerDes enables efficient data transmission over a limited number of isolators. As a result, the number of isolators can be reduced relative to the implementation of FIG. 1.

Isolated device 101 connects a terminal 100 to a terminal 200 in an isolated fashion, due to the presence of isolation barrier 102. Isolation barrier 102 represents an electrical separation designed to prevent direct electrical conduction between two parts of isolated device 101 while still allowing communication through other means, such as magnetic, capacitive, or optical coupling. In some embodiments, isolation barrier is defined by more than one isolator (e.g., one isolator per direction of transmission), as shown in the example of FIG. 2. In other embodiments, isolated device 101 may include a single isolator that defines the entire isolation barrier 102. The single isolator supports communication in both directions.

In one example, terminal 100 represents the high-voltage side (e.g., terminal 100 may include an input power source and/or switching circuitry) while terminal 200 represents the low-voltage side (e.g., terminal 200 may include a microcontroller or logic circuitry). In this implementation, isolated device 101 supports sixteen channels although other numbers of channels are also possible. Each channel defines a signal path connecting a port of terminal 100 to a port of terminal 200 (e.g., port P1 of terminal 100 to port P1 of terminal 200).

As described in detail further below, isolated device 101 allows the user to program each channel independently of the other channels. An external processor 160 transfers user input to isolated device 101. The user input may include i) data indicating which channel are to be activated and which channels are to be deactivated and/or ii) data indicating the desired direction for each channel and/or iii) data indicating the desired speed at which each channel is to transmit and/or iv) data indicating the desired delay associated with each channel. Controller 150, internal to isolated device 101, receives the input data and controls the channels accordingly.

Isolated device 101 further includes serializers 112 and 122, deserializers 114 and 124, transmitters (TX) 116 and 128, receivers (RX) 118 and 126 and delay units 130. Serializer 112 and deserializer 114 form SerDes 110 while serializer 122 and deserializer 124 form SerDes 120. SerDes 110 and 120 are coupled to opposite sides of isolation barrier 102. As disclosed herein, two sides of an isolation barrier are said to be opposite one another to indicate that the sides are galvanically isolated from one another by the barrier, whether the barrier is implemented magnetically, capacitively, optically, acoustically or otherwise. Depending on the size of the isolator, the opposite sides may be spatially adjacent to one another (e.g., in capacitive isolators) or may be spatially separated (e.g., in optical isolators where the barrier is implemented using light pipes or fibers). Either way, opposite sides are galvanically isolated from one another.

Serializer 112 includes multiple inputs, each input being coupled to a port of terminal 100 (see, e.g., ports P1, P2...P16). Serializer 112 converts parallel input data into a single serial data stream at its output. The output of serializer 112 is coupled to TX 116, which includes circuitry configured to produce signals that can pass through the isolation barrier. For example, in embodiments in which isolator 106 in optical in nature, TX 116 includes a light emitting diode (LED). RX 126 includes circuitry configured to detect signals that have passed through the isolation barrier. For example, in embodiments in which isolator 106 in optical in nature, RX 126 includes a photodetector. The output of RX 126 is coupled to the input of deserializer 124, which converts serial input data into parallel data streams at its outputs. Each output of deserializer 124 is coupled to a port of terminal 200. In some embodiments, a programmable delay unit 130 is interposed between each output of deserializer 124 and each port of terminal 200 (see, e.g., delay units "D1," "D2"..."D16"). The ports of terminals 100 and 200 may serve either as inputs or as outputs, depending upon the desired direction of transmission associated with each channel.

Similarly, serializer 122 includes multiple inputs, each input being coupled to a port of terminal 200. Serializer 122 converts parallel input data into a single serial data stream at its output. The output of serializer 122 is coupled to isolator 108 through TX 128. The output of RX 118 is coupled to the input of deserializer 114, which converts serial input data into parallel data streams at its outputs. Each output of deserializer 114 is coupled to a port of terminal 100 (see, e.g., ports P1, P2...P16). In some embodiments, a programmable delay unit 130 is interposed between each output of deserializer 114 and each port of terminal 100 (see, e.g., delay units "D17," "D18"..."D32").

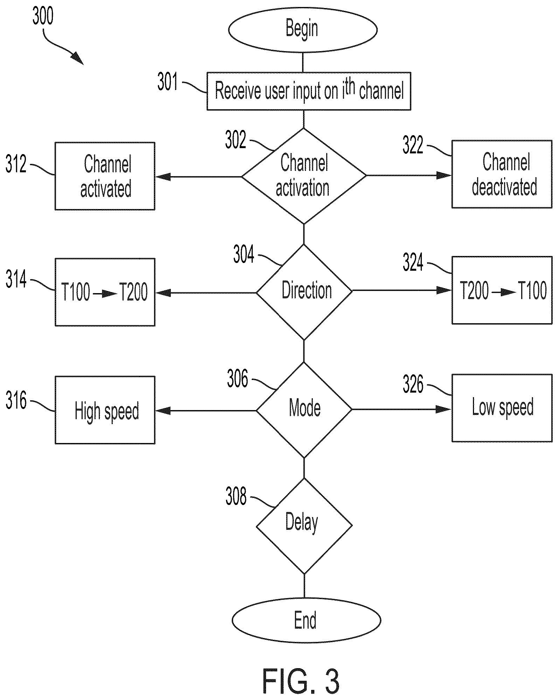

FIG. 3 is a flow chart illustrating a method for controlling a software programmable isolated device, in accordance with some embodiments. Method 300 may be executed using controller 150 or another controller that is external to isolated device 101. At act 301, the controller receives user input indicative of the desired characteristics for the i^{th} channel of an isolated device (where i can be 1, 2...16 in the example of FIG. 2). The controller may receive the user input from an external processor (e.g., processor 160).

At act 302, the controller determines whether to activate (act 312) or deactivate (322) the i^{th} channel, depending upon the user input. Depending on the determination, the controller activates the channel (at act 312) or deactivates it (act 322). When activated, a channel permits passage of signals across the isolation barrier; when deactivated, it does not. Activation and deactivation of a channel may be performed in any of numerous ways. In one example, the controller may turn a switch on (for activation) or off (for deactivation), the switch being positioned along the channel's signal path. The switch may be internal to SerDes 110 or SerDes 120 in some embodiments, may be located between the inputs of the serializer 112 and the ports of terminal 100 (and/or between the inputs of the serializer 122 and the ports of terminal 200), and/or may be located between the outputs of the deserializer 114 and the ports of terminal 100 (and/or between the outputs of the deserializer 124 and the ports of terminal 200).

At act 304, the controller selects, based on the user input, the direction of transmission for the i^{th} channel between a first direction (act 314) oriented from terminal 100 to terminal 200 and a second direction (act 324) oriented from terminal 200 to terminal 100. The selected direction of transmission determines whether terminal 100 is to transmit signals directed to terminal 200, or *vice versa.* Selecting the direction of transmission may be performed in any of numerous ways. For example, if the controller selects the direction oriented from terminal 100 to terminal 200, the signal path associated with the channel passes through serializer 112, TX 116, isolator 106, RX 126 and deserializer 124. By contrast, if the controller selects the direction oriented from terminal 200 to terminal 100, the signal path associated with the channel passes through serializer 122, TX 128, isolator 108, RX 118 and deserializer 114. Switches (not shown in FIG. 2) may be used to selectively connect a terminal's port to either the input of the serializer or the output deserializer.

At act 306, the controller selects, based on the user input, the mode of operation for the i^{th} channel between a high-speed mode (act 316) and a low-speed mode (act 326). In the high-speed mode, the channel is configured to transmit at a higher data rate than in the low-speed mode. This allows the user to set to the high-speed mode only those channels for which high speed is desirable. Channels for which high speed is of less importance can be set to the low-speed mode, thereby saving power. In some embodiments, the data rate associated with the high-speed mode may be between 100Mb/s and 1Gb/s and the data rate associated with the low-speed mode may be between 1Mb/s and 100Mb/s. In some embodiments, the SerDes can have, for each channel, two distinct types of buffers: a Low-Voltage Differential Signaling (LVDS) buffer and a Complementary Metal-Oxide-Semiconductor (CMOS) buffer. In the high-speed mode, the controller selects the LVDS buffer while in the low-speed mode, the controller selects the CMOS buffer. The primary difference between CMOS buffer and an LVDS buffer lies in how they handle data transmission, especially regarding signal type, speed, and power consumption. CMOS buffers generally operate at slower speeds compared to LVDS buffers, making them more suitable for lower-frequency applications. LVDS buffers are designed for high-speed data transmission, making them ideal for applications such as video transmission, high-speed communication interfaces, and data buses.

At act 308, the controller sets the delay to be introduced along the signal path associated with the i^{th} channel. This may be performed by controlling the delay unit 130 to produce the desired delay. Allowing the user to select different delays for different channels may be particularly beneficial in reducing jitter.

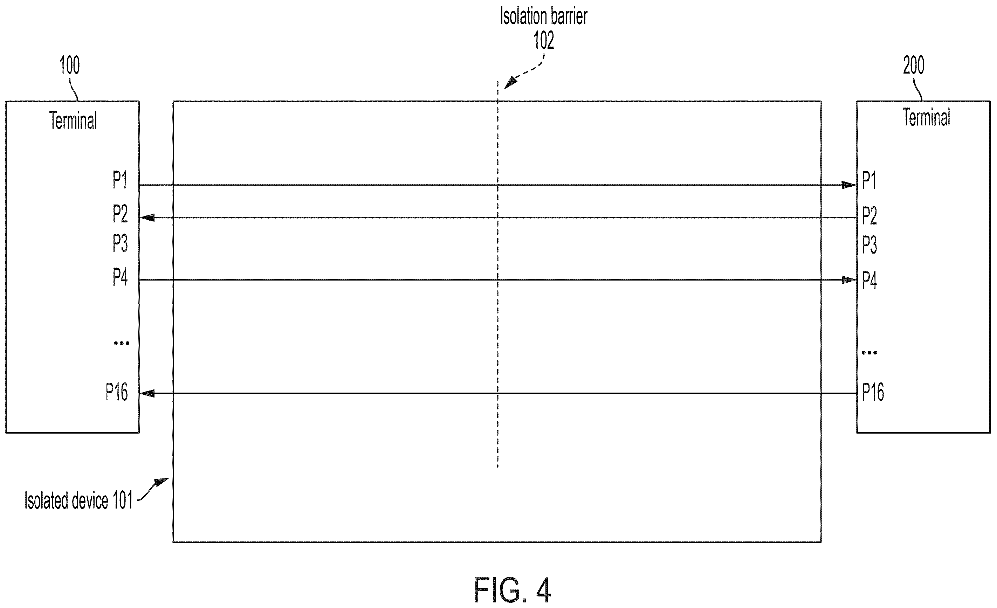

FIG. 4 is a block diagram illustrating the isolated device of FIG. 2 in a particular state, in accordance with some embodiments. The first channel extends between port P1 of terminal 100 and port P1 of terminal 200; the second channel extends between port P2 of terminal 100 and port P2 of terminal 200; the third channel extends between port P3 of terminal 100 and port P3 of terminal 200; the fourth channel extends between port P4 of terminal 100 and port P4 of terminal 200; the sixteenth channel extends between port P16 of terminal 100 and port P16 of terminal 200. In the interest of clarity, the other channels are not shown. In this example, the controller has activated the first, second, fourth and sixteenth channels and has deactivated the third channel. Further, the controller has selected the first direction (from terminal 100 to terminal 200) for the first and fourth channels, and has selected the second direction (from terminal 200 to terminal 100) for the second and sixteenth channels. Although not shown in FIG. 4, the controller may individually set the mode of operation and the amount of delay associated with each channel.

In one example, at least some of the channels oriented from terminal 100 to terminal 200 may be set to the high-speed mode and may support transmission of data. Additionally, at least one of the channels oriented from terminal 200 to terminal 100 may be set to the low-speed mode and may support transmission of clock. The ability to send a clock back to terminal 100, coupled with the ability to individually control the delay associated with each channel, may help the user to reduce the jitter present in each channel.

Use of ordinal terms such as "first," "second," "third," etc., in the claims to modify a claim element does not by itself connote any priority, precedence, or order of one claim element over another or the temporal order in which acts of a method are performed, but are used merely as labels to distinguish one claim element having a certain name from another element having a same name (but for use of the ordinal term) to distinguish the claim elements.

Having thus described several aspects of at least one embodiment, it is to be appreciated that various alterations, modifications, and improvements will readily occur to those skilled in the art. Such alterations, modifications, and improvements are intended to be part of this disclosure and are intended to be within the spirit and scope of the principles described herein. Accordingly, the foregoing description and drawings are by way of example only.

The terms "couple," "coupled," and "coupling," when used in connection with electrical components, are to be interpreted broadly to include both direct and indirect coupling. Two electrical components are considered directly coupled if there are no intervening components between them. In contrast, two electrical components are considered indirectly coupled if there is at least one intervening component between them, provided that the intervening component does not alter the general nature of the interaction between the electrical components.

There follows a list of numbered features defining particular embodiments of the present disclosure. Where a numbered feature refers to one or more earlier numbered features then those features should be considered together in combination.
1. An isolated device comprising:
   an isolation barrier;
   a first serializer/deserializer (SerDes) coupled to a first side of the isolation barrier and a second SerDes coupled to a second side of the isolation barrier opposite the first side;
   a plurality of programmable channels coupled to the first and second SerDes, wherein each programmable channel, when activated, permits passage of signals across the isolation barrier; and
   a controller configured to individually activate or deactivate each channel of the plurality of programmable channels.
2. The isolated device of feature 1, wherein the controller is configured to individually activate or deactivate each channel of the plurality of programmable channels based on input provided by a user of the isolated device.
3. The isolated device of feature 1 or 2, wherein the controller is further configured to select, for each channel of the plurality of programmable channels, a direction of transmission between a first direction oriented from the first SerDes to the second SerDes and a second direction oriented from the second SerDes to the first SerDes.
4. The isolated device of feature 3, wherein the controller is configured to select the direction of transmission for each channel based on input provided by a user of the isolated device.
5. The isolated device of any of features 1 to 4, wherein the controller is further configured to select, for each channel of the plurality of programmable channels, a mode of operation between a high-speed mode and a low-speed mode, wherein the high-speed mode results in a higher data rate than the low-speed mode.
6. The isolated device of feature 5, wherein the controller is configured to select the mode of operation for each channel based on input provided by a user of the isolated device.
7. The isolated device of feature 5 or 6, wherein selecting the high-speed mode comprises selecting an LVDS buffer and selecting the low-speed mode comprises selecting a CMOS buffer.
8. The isolated device of any of features 1 to 7, wherein each channel of the plurality of programmable channels comprises a programmable delay unit, and wherein the controller is further configured to individually control each delay unit associated with a respective channel to introduce a delay of a respective amount in the channel.
9. The isolated device of feature 8, wherein the controller is configured to individually control each delay unit based on input provided by a user of the isolated device.
10. An isolated device comprising:
   an isolation barrier;
   a first transmitter coupled to a first side of the isolation barrier, and a first receiver coupled to a second side of the isolation barrier opposite the first side;
   a second transmitter coupled to the second side of the isolation barrier, and a second receiver coupled to the first side of the isolation barrier;
   a first serializer having a plurality of inputs and an output coupled to the first transmitter;
   a second serializer having a plurality of inputs and an output coupled to the second transmitter;
   a first deserializer having an input coupled to the first receiver and a plurality of outputs coupled to the inputs of the second serializer; and
   a second deserializer having an input coupled to the second receiver and a plurality of outputs coupled to the inputs of the first serializer.
11. The isolated device of feature 10, further comprising a first plurality of programmable delay units coupled to the outputs of the first deserializer and a second plurality of programmable delay units coupled to the outputs of the second deserializer.
12. The isolated device of feature 11, further comprising a controller configured to set delays by controlling the first and second pluralities of programmable delay units.
13. The isolated device of any of features 10 to 12, further comprising a controller configured to individually connect or disconnect each input of the plurality of inputs of the first serializer to the first side of the isolated barrier.
14. The isolated device of feature 13, wherein the controller is further configured to individually connect or disconnect each output of the plurality of outputs of the second deserializer to the first side of the isolated barrier.
15. The isolated device of any of features 10 to 14, wherein the isolated barrier comprises a first isolator and a second isolator, the first isolator being coupled to the first transmitter and the first receiver, the second isolator being coupled to the second transmitter and the second receiver.
16. A method for controlling an isolated device comprising an isolation barrier, a first serializer/deserializer (SerDes) coupled to a first side of the isolation barrier and a second SerDes coupled to a second side of the isolation barrier opposite the first side, and a plurality of programmable channels coupled to the first and second SerDes, the method comprising:
   individually activating or deactivating each channel of the plurality of programmable channels to connect or disconnect the first SerDes from the second SerDes through the isolation barrier; and
   selecting, for each activated channel, a direction of transmission between a first direction oriented from the first SerDes to the second SerDes and a second direction oriented from the second SerDes to the first SerDes.
17. The method of feature 16, wherein individually activating or deactivating each channel and selecting, for each activated channel, a direction of transmission is performed based on input provided by a user of the isolated device.
18. The method of feature 16 or 17, further comprising selecting, for each activated channel, a mode of operation between a high-speed mode and a low-speed mode, wherein the high-speed mode results in a higher data rate than the low-speed mode.
19. The method of feature 18, wherein selecting the high-speed mode comprises selecting an LVDS buffer and selecting the low-speed mode comprises selecting a CMOS buffer.
20. The method of any of features 16 to 19, wherein each channel of the plurality of programmable channels comprises a programmable delay unit, and wherein the method further comprises:
   individually controlling each delay unit associated with a respective channel to introduce a delay of a respective amount in the channel.

## Claims

1. An isolated device comprising:
an isolation barrier;
a first serializer/deserializer (SerDes) coupled to a first side of the isolation barrier and a second SerDes coupled to a second side of the isolation barrier opposite the first side;
a plurality of programmable channels coupled to the first and second SerDes, wherein each programmable channel, when activated, permits passage of signals across the isolation barrier; and
a controller configured to individually activate or deactivate each channel of the plurality of programmable channels.

2. The isolated device of claim 1, wherein the controller is configured to individually activate or deactivate each channel of the plurality of programmable channels based on input provided by a user of the isolated device.

3. The isolated device of claim 1 or 2, wherein the controller is further configured to select, for each channel of the plurality of programmable channels, a direction of transmission between a first direction oriented from the first SerDes to the second SerDes and a second direction oriented from the second SerDes to the first SerDes.

4. The isolated device of claim 3, wherein the controller is configured to select the direction of transmission for each channel based on input provided by a user of the isolated device.

5. The isolated device of any of claims 1 to 4, wherein the controller is further configured to select, for each channel of the plurality of programmable channels, a mode of operation between a high-speed mode and a low-speed mode, wherein the high-speed mode results in a higher data rate than the low-speed mode.

6. The isolated device of claim 5, wherein the controller is configured to select the mode of operation for each channel based on input provided by a user of the isolated device.

7. The isolated device of claim 5 or 6, wherein selecting the high-speed mode comprises selecting an LVDS buffer and selecting the low-speed mode comprises selecting a CMOS buffer.

8. The isolated device of any of claims 1 to 7, wherein each channel of the plurality of programmable channels comprises a programmable delay unit, and wherein the controller is further configured to individually control each delay unit associated with a respective channel to introduce a delay of a respective amount in the channel.

9. The isolated device of claim 8, wherein the controller is configured to individually control each delay unit based on input provided by a user of the isolated device.

10. An isolated device comprising:
an isolation barrier;
a first transmitter coupled to a first side of the isolation barrier, and a first receiver coupled to a second side of the isolation barrier opposite the first side;
a second transmitter coupled to the second side of the isolation barrier, and a second receiver coupled to the first side of the isolation barrier;
a first serializer having a plurality of inputs and an output coupled to the first transmitter;
a second serializer having a plurality of inputs and an output coupled to the second transmitter;
a first deserializer having an input coupled to the first receiver and a plurality of outputs coupled to the inputs of the second serializer; and
a second deserializer having an input coupled to the second receiver and a plurality of outputs coupled to the inputs of the first serializer.

11. A method for controlling an isolated device comprising an isolation barrier, a first serializer/deserializer (SerDes) coupled to a first side of the isolation barrier and a second SerDes coupled to a second side of the isolation barrier opposite the first side, and a plurality of programmable channels coupled to the first and second SerDes, the method comprising:
individually activating or deactivating each channel of the plurality of programmable channels to connect or disconnect the first SerDes from the second SerDes through the isolation barrier; and
selecting, for each activated channel, a direction of transmission between a first direction oriented from the first SerDes to the second SerDes and a second direction oriented from the second SerDes to the first SerDes.

12. The method of claim 11, wherein individually activating or deactivating each channel and selecting, for each activated channel, a direction of transmission is performed based on input provided by a user of the isolated device.

13. The method of claim 12 or 13, further comprising selecting, for each activated channel, a mode of operation between a high-speed mode and a low-speed mode, wherein the high-speed mode results in a higher data rate than the low-speed mode.

14. The method of claim 13, wherein selecting the high-speed mode comprises selecting an LVDS buffer and selecting the low-speed mode comprises selecting a CMOS buffer.

15. The method of any of claims 11 to 14, wherein each channel of the plurality of programmable channels comprises a programmable delay unit, and wherein the method further comprises:
individually controlling each delay unit associated with a respective channel to introduce a delay of a respective amount in the channel.
